# EUROPEAN PATENT SPECIFICATION

(11) **EP 4 503 140 B1**
(45) Date of publication and mention of the grant of the patent: **23.09.2026**
(21) Application number: 23834648.0
(22) Date of filing: 26.06.2023
(51) Int. Cl.: H10F 77/30, H10F 71/00

(54) **METHOD FOR MANUFACTURING A SOLAR CELL**
VERFAHREN ZUR HERSTELLUNG EINER SOLARZELLE
PROCÉDÉ DE FABRICATION D'UNE CELLULE SOLAIRE

(30) Priority: 08.07.2022 CN 202210804635
(43) Date of publication of application: 05.02.2025
(73) Proprietor: Tongwei Solar (Meishan) Co., Ltd., Meishan, Sichuan 620041 (CN)
(72) Inventor: SHI, Xinxin, Meishan, Sichuan 620041 (CN); HUANG, Zhi, Meishan, Sichuan 620041 (CN)
(74) Representative: Michalski Hüttermann & Partner mbB
(86) International application number: PCT/CN2023/102337
(87) International publication number: WO 2024/007874

(56) References cited:
- CN-A- 108 962 999
- CN-A- 108 962 999
- CN-A- 109 087 956
- CN-A- 110 061 073
- CN-A- 110 061 073
- CN-A- 112 635 622
- CN-A- 112 864 279
- CN-A- 115 172 474
- JP-A- 2018 022 718

## Description

### TECHNICAL FIELD

The present disclosure relates to the technical field of photovoltaics, particularly relates to a method for manufacturing a solar cell.

### BACKGROUND

Photovoltaic modules, as the fundamental units for photovoltaic power generation, are vulnerable to environmental factors and are prone to experiencing potential induced degradation (PID) during operation. PID occurs mainly due to the following reasons. Moisture enters the modules from the air in humid environments and hydrolyzes ethylene vinyl acetate (EVA) to produce acetic acid, which reacts with alkali salts precipitated from the glass to generate freely mobile alkali metal ions such as Na⁺, Ca²⁺, Fe²⁺, and Fe³⁺. When subjected to an external electric field, these ions can migrate to the surface of the cell and penetrate the reflection reduction film of the cell, causing a loss of its passivation effect. Additionally, these ions can further migrate into the cell and create an internal electric field with the holes generated by the PN junction, which limits the output of photogenerated carriers and ultimately leads to power degradation of the modules, thereby significantly impacting the power generation capacity.

CN 108962999 A relates to a reflectivity reducing composite film for solar cells, which comprises a base material (1) and a composite film layer, wherein the composite film layer comprises a first SiNlayer (2), a second SiN layer (3), an SiON layer (4) and an SiO2 layer (5) in sequence from the inside out; the refractive index of the first SiN layer (2) is greater than or equal to 2.0; the refractive index of the second SiN layer (3) is less than 2.0, and the thickness of the second SiN layer (3) is 60-80nm; the thickness of the SiON layer (4) is less than or equal to 30nm; and the thickness of the SiO2 layer (5) is less than or equal to 20nm.

CN 110061073 A relates to a crystalline silicon solar cell and a preparation method thereof, wherein a surface of a cell piece is provided with a barrier film; the surface of the finished cell piece is further provided with the barrier film in a coated manner to form an ion diffusion barrier layer, and one surface or two surfaces of the finished battery piece are wrapped to be used as a diffusion barrier layer for blocking external ions from migrating to the battery, and therefore, the PID resistance of the cell is improved, the passivation and anti-reaction effects are improved at the same time, and the photoelectric conversion efficiency of the battery is improved; the coating film on the surface of the cell piece can also be used for protecting the electrode from oxidation and resisting aging.

### SUMMARY

The present disclosure provides a method for manufacturing a solar cell, which can ensure good reflection reduction effects on front and back sides of the solar cell while improving the PID resistance of the solar cell.

The embodiments of the present disclosure are as follows.

In a first aspect, the embodiments of the present disclosure provide a method for manufacturing a solar cell, including: providing a semi-finished silicon wafer, and forming a first silicon oxide layer and a second silicon oxide layer respectively on a front side and a back side of the semi-finished silicon wafer through an atomic layer deposition process.

The semi-finished silicon wafer includes at least one back silicon nitride layer, an aluminum oxide layer, a silicon layer, at least one front silicon nitride layer, a silicon oxynitride layer, and a third silicon oxide layer arranged in sequence along a thickness direction thereof. The first silicon oxide layer is bound to a surface of the third silicon oxide layer, and the second silicon oxide layer is bound to a surface of the back silicon nitride layer. The first silicon oxide layer and the second silicon oxide layer each have a thickness of 5 to 10 nm.

In the above technical solutions, the method for manufacturing the solar cell according to the present disclosure can form dense silicon oxide layers respectively on the front and back sides of the semi-finished silicon wafer through the atomic layer deposition process, which effectively blocks alkali metal ions from the glass of the module from passing through the films/layers of the solar cell and into the silicon wafer to damage the PN junction, thereby enhancing the PID resistance of the solar cell. Additionally, the dense silicon oxide layers formed through the atomic layer deposition process do not affect the reflection reduction effects on the front and back sides of the solar cell, maintaining the high photoelectric conversion efficiency of the solar cell.

The above thickness of the silicon oxide layers is appropriate and beneficial for enhancing the PID resistance of the solar cell while also being capable of maintaining the high photoelectric conversion efficiency of the solar cell.

In the first aspect, in a second possible embodiment of the present disclosure, the atomic layer deposition process includes the following steps:
placing the semi-finished silicon wafer in a reaction chamber, introducing a gaseous silicon-based precursor into the reaction chamber at a flow rate of 10 to 50 sccm for 2 to 5 seconds, and then introducing a gaseous oxidant precursor into the reaction chamber at a flow rate of 10 to 50 sccm for 5 to 15 seconds.

The above steps are recycled for 50 to 100 times.

Optionally, the reaction chamber is under vacuum condition before introducing the gaseous silicon-based precursor.

In this embodiment, the gaseous silicon-based precursor is firstly introduced into the reaction chamber so that the gaseous silicon-based precursor can be adsorbed onto a surface of the semi-finished silicon wafer substrate, and then the gaseous oxidant precursor is introduced into the reaction chamber so that the gaseous oxidant precursor reacts with the gaseous silicon-based precursor on the surface of the semi-finished silicon wafer substrate to form a silicon oxide film. The silicon oxide film deposited in a single cycle has a thickness of 0.1 to 0.15 nm. By cycling the deposition for 50 to 100 times, the silicon oxide layer has a thickness of 5 to 10 nm can be obtained.

In the first aspect, in a third possible embodiment of the present disclosure, the silicon-based precursor includes hexachlorodisilane, bis(diethylamino)silane, tris(dimethylamino)silane, trisilylamine, or any combination thereof, and the oxidant includes oxygen, ozone, or a combination thereof.

In the first aspect, in a fourth possible embodiment of the present disclosure, a pressure in the reaction chamber is 2 to 50 mbar, and a temperature of the semi-finished silicon wafer is 150 to 400 °C.

In the first aspect, in a fifth possible embodiment of the present disclosure, after the introducing the gaseous silicon-based precursor each time, the gaseous silicon-based precursor is adsorbed onto a surface of the semi-finished silicon wafer, and the method includes expelling any redundant gaseous silicon-based precursor from the reaction chamber before the introducing the gaseous oxidant precursor into the reaction chamber; and a reaction of the gaseous oxidant precursor and the gaseous silicon-based precursor adsorbed onto the surface of the semi-finished silicon wafer is performed in the reaction chamber, and the method includes expelling any unreacted gaseous silicon-based precursor and any unreacted gaseous oxidant precursor from the reaction chamber after the reaction is completed and before the next cycle of deposition.

In the first aspect, in a sixth possible embodiment of the present disclosure, the semi-finished silicon wafer is manufactured by the following steps:
depositing a back coating layer and a front coating layer respectively on a back side and a front side of a silicon wafer;
wherein the back coating layer on the back side includes a first silicon nitride layer, a second silicon nitride layer, a third silicon nitride layer, and the aluminum oxide layer, and the front coating layer on the front side includes a fourth silicon nitride layer, a fifth silicon nitride layer, a sixth silicon nitride layer, the silicon oxynitride layer, and the third silicon oxide layer.

In the first aspect, in a seventh possible embodiment of the present disclosure, the aluminum oxide layer, the third silicon nitride layer, the second silicon nitride layer, and the first silicon nitride layer are sequentially deposited on the back side of the silicon wafer through a vapor deposition process.

Optionally, the third silicon nitride layer has a refractive index of 2.20 to 2.30, the second silicon nitride layer has a refractive index of 2.09 to 2.15, and the first silicon nitride layer has a refractive index of 2.00 to 2.06.

Optionally, the back coating layer on the back side has a refractive index of 2.10 to 2.15.

In this embodiment, the coating layer on the back side of the solar cell manufactured in the present disclosure has a relatively low refractive index, so that the solar cell has a good short-wavelength response and can absorb more blue light, which leads to a high short-circuit current and a high open-circuit voltage and improves the photovoltaic conversion efficiency of the solar cell.

In the first aspect, in a eighth possible embodiment of the present disclosure, the fourth silicon nitride layer, the fifth silicon nitride layer, the sixth silicon nitride layer, the silicon oxynitride layer, and the third silicon oxide layer are sequentially deposited on the front side of the silicon wafer through a vapor deposition process.

Optionally, the fourth silicon nitride layer has a refractive index of 2.20 to 2.30, the fifth silicon nitride layer has a refractive index of 2.09 to 2.17, the sixth silicon nitride layer has a refractive index of 2.03 to 2.06, and the silicon oxynitride layer has a refractive index of 1.55 to 1.90.

Optionally, the front coating layer on the front side has a refractive index of 2.00 to 2.05.

In this embodiment, the coating layer on the front side of the solar cell manufactured in the present disclosure has a relatively low refractive index, so that the solar cell has a good short-wavelength response and can absorb more blue light, which leads to a high short-circuit current and a high open-circuit voltage and improves the photovoltaic conversion efficiency of the solar cell.

In a second aspect, a solar cell manufactured by the method as described above is provided.

In the above technical solutions, the solar cell in the present disclosure has a good PID resistance and a high photovoltaic conversion efficiency.

### BRIEF DESCRIPTION OF THE DRAWINGS

FIG. 1 is a schematic structural view of a semi-finished silicon wafer according to embodiments of the present disclosure.
FIG. 2 is a schematic structural view of a solar cell according to embodiments of the present disclosure.

Description of reference numerals: 10-semi-finished silicon wafer; 101-first silicon nitride layer; 102-second silicon nitride layer; 103-third silicon nitride layer; 104-aluminium oxide layer; 105-silicon layer; 106-fourth silicon nitride layer; 107-fifth silicon nitride layer; 108-sixth silicon nitride layer; 109-silicon oxynitride layer; 110-third silicon oxide layer; 20-finished silicon wafer; 201-first silicon oxide layer; 202-second silicon oxide layer.

### DETAILED DESCRIPTION

Unless otherwise defined, all technical and scientific terms used herein have the same meaning as commonly understood by one of ordinary skill in the art to which the present disclosure belongs. The terminology used herein in the description of the present disclosure is for the purpose of describing particular embodiments only and is not intended to be limiting of the present disclosure. The term "and/or" used herein includes any or all combinations of one or more related listed items.

In the current industry, PID degradation in mainstream PERC cell products is primarily categorized into front PID failure and back PID failure. The mechanisms behind these two types of failures are slightly different, and the measures to address them also vary.

To mitigate front PID failure, optimization of encapsulation materials is mainly performed at the module level to prevent the ingress of external moisture. At the cell level, process optimizations are mainly implemented. For example, a very thin silicon oxide film is grown between the silicon wafer and the front silicon nitride film by the methods such as thermal oxidation and ozone treatment in order to block alkali metal ions from migrating into the silicon wafer; or a silicon nitride layer with a high refractive index is used to enhance the passivation effect and block the free and positively charged ions, while depositing SiOₓN_{y} with a low refractive index on the top layer by PECVD to reduce the overall refractive index of the films/layers, increase the proportion of incident light, and improve both the short-circuit current and the photoelectric conversion efficiency. Further deposition of silicon oxide with a lower refractive index on the top layer can significantly enhance the reflection reduction effect of the films/layers and improve the short-wave response.

The silicon oxide layer formed between the silicon wafer and the front silicon nitride film by the methods such as thermal oxidation and ozone treatment is very thin, approximately 5-6 µm. In such structure, the PID resistance mainly relies on the silicon oxide layer formed between the silicon wafer and the front silicon nitride film. With the trend toward cost reduction in modules, substantial changes in module materials have made it challenging for the silicon oxide layer between the silicon wafer and the front silicon nitride film to resist the migration of alkali metal ions into the silicon wafer, which can damage the PN junction and exacerbate the power degradation of the modules. While increasing the thickness of the silicon oxide layer at the bottom of the silicon wafer can be achieved by extending the duration of thermal oxidation or ozone treatment, this approach significantly impacts the production capacity and may lead to a decline in the photoelectric conversion efficiency of the solar cells.

Moreover, to maximize the enhancement of the reflection reduction effect of the front films/layers and increase the short-wave response, the outermost silicon oxide layer prepared by PECVD often reaches a thickness of 25 nm, accounting for about one-third of the total film thickness. However, this silicon oxide layer does not possess the ability to resist PID, and its presence may lead to insufficient total thickness of the silicon nitride layer, making PID failure more likely.

Based on the current two-in-one PECVD equipment, directly depositing silane and an oxygen-containing gas together on the front silicon nitride top layer can obtain composite films/layers with a good reflection reduction effect. Although this method has significant advantages in terms of photoelectric conversion efficiency and manufacturing costs, it has a disadvantage in front PID resistance due to the low refractive index of the overall films/layers. If the front films/layers solely employ a high-refractive-index silicon nitride layer, the overall refractive index can reach as high as 2.12 to 2.15, which significantly enhances the front PID resistance. However, this results in a loss of short-wave absorption in the cells, leading to a decrease in photoelectric conversion efficiency by 0.1% to 0.15%.

The inventors have found that in the method where a silicon carbon oxide film with a higher refractive index is deposited at the bottom to enhance passivation and PID resistance, although the surface layer uses silicon oxide to lower the overall refractive index and improve the reflection reduction effect, the silicon oxide film produced by PECVD has poor density and a loose and porous structure, which makes it less effective at resisting the migration of alkali metal ions compared to the silicon oxide produced by thermal oxidation. On the other hand, the silicon carbide film, as a high-refractive-index bottom layer, has a high extinction coefficient, and if it is too thick, it can lead to extinction, causing the incident light to be absorbed by the front film and resulting in a loss of photogenerated carriers. Therefore, when designing the front reflection reduction film of the solar cell to enhance the PID resistance, it is essential to consider the characteristics of each of films/layers simultaneously in order to improve the PID resistance while maintaining good reflection reduction effect.

The solar cell and the manufacturing method therefor according to embodiments of the present disclosure will be described in detail below.

The present disclosure provides a manufacturing method for a solar cell, including providing a semi-finished silicon wafer and forming a first silicon oxide layer and a second silicon oxide layer respectively on a front side and a back side of the semi-finished silicon wafer through an atomic layer deposition process.

The first silicon oxide layer and the second silicon oxide layer each have a thickness of 5 to 10 nm.

The above thickness of the silicon oxide layers is appropriate and beneficial for enhancing the PID resistance of the solar cell while also maintaining a high photoelectric conversion efficiency of the solar cell.

In an embodiment of the present disclosure, the first silicon oxide layer and the second silicon oxide layer each have a thickness of 8 nm. In other embodiments of the present disclosure, the first silicon oxide layer and the second silicon oxide layer can each have a thickness of 5 nm, 6 nm, 7 nm, 9 nm, or 10 nm.

It should be noted that the thicknesses of the first silicon oxide layer and the second silicon oxide layer can be the same or different.

The atomic layer deposition process includes:
placing the semi-finished silicon wafer in a reaction chamber; under vacuum condition, firstly introducing a gaseous silicon-based precursor into the reaction chamber, so that the gaseous silicon-based precursor is chemically adsorbed onto a surface of the semi-finished silicon wafer substrate, and then introducing a gaseous oxidant precursor into the reaction chamber after expelling any redundant gaseous silicon-based precursor from the reaction chamber, so that the gaseous oxidant precursor reacts with the silicon-based precursor on the surface of the semi-finished silicon wafer substrate to form a silicon oxide film; and expelling any unreacted gaseous silicon-based precursor and any unreacted gaseous oxidant precursor from the reaction chamber.

The above steps are cycled, and the thickness of the resulting silicon oxide layer is controlled by adjusting the number of cycles. Since the thickness of the silicon oxide deposited in a single cycle is approximately 0.1 to 0.15 nm, a total of 50 to 100 cycles can produce a silicon oxide layer with a thickness of 5 to 10 nm.

The silicon-based precursor includes hexachlorodisilane, bis(diethylamino)silane, tris(dimethylamino)silane, trisilylamine, or any combination thereof.

The oxidant includes oxygen, ozone, or a combination thereof.

The gaseous silicon-based precursor is introduced for a time period of 2 to 5 seconds, at a flow rate of 10 to 50 sccm.

In an embodiment of the present disclosure, the gaseous silicon-based precursor is introduced for a time period of 3 seconds, at a flow rate of 30 sccm. In other embodiments of the present disclosure, the gaseous silicon-based precursor can be introduced for a time period of 2 seconds, 2.5 seconds, 3.5 seconds, 4 seconds, 4.5 seconds, or 5 seconds, at a flow rate of 10 sccm, 15 sccm, 20 sccm, 25 sccm, 35 sccm, 40 sccm, 45 sccm, or 50 sccm.

The gaseous oxidant precursor is introduced for a time period of 5 to 15 seconds, at a flow rate of 10 to 50 sccm.

In an embodiment of the present disclosure, the gaseous oxidant precursor is introduced for a time period of 10 seconds, at a flow rate of 30 sccm. In other embodiments of the present disclosure, the gaseous silicon-based precursor can be introduced for a time period of 5 seconds, 6 seconds, 7 seconds, 8 seconds, 9 seconds, 11 seconds, 12 seconds, 13 seconds, 14 seconds, or 15 seconds, at a flow rate of 30 sccm as well.

The reaction chamber has a pressure of 2 to 50 mbar therein.

In an embodiment of the present disclosure, the reaction chamber has a pressure of 20 mbar therein. In other embodiments of the present disclosure, the reaction chamber can have a pressure of 2 mbar, 5 mbar, 10 mbar, 15 mbar, 25 mbar, 30 mbar, 35 mbar, 40 mbar, 45 mbar, or 50 mbar.

The semi-finished silicon wafer is at a temperature of 150 to 400 °C.

In an embodiment of the present disclosure, the semi-finished silicon wafer is at a temperature of 250 °C. In other embodiments of the present disclosure, the semi-finished silicon wafer can be at a temperature of 150 °C, 200 °C, 300 °C, 350 °C, or 400 °C.

A method for expelling the redundant gaseous silicon-based precursor from the reaction chamber or expelling the unreacted gaseous silicon-based precursor and the unreacted gaseous oxidant precursor from the reaction chamber includes pumping or inert gas purging.

When the inert gas purging is used, the inert gas purging is performed for a time period of 0.5 to 20 seconds, at a flow rate of 100 to 3000 sccm.

The atomic layer deposition process can be a plasma-enhanced atomic layer deposition process.

The semi-finished silicon wafer includes at least one silicon nitride layer, an aluminum oxide layer, a silicon layer, at least one silicon nitride layer, a silicon oxynitride layer, and a third silicon oxide layer arranged in sequence along a thickness direction thereof.

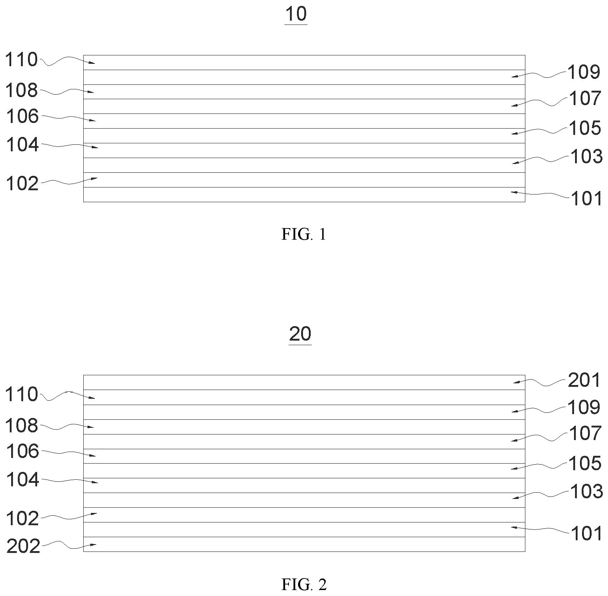

Referring to FIG. 1, the semi-finished silicon wafer 10 includes a first silicon nitride layer 101, a second silicon nitride layer 102, a third silicon nitride layer 103, an aluminum oxide layer 104, a silicon layer 105, a fourth silicon nitride layer 106, a fifth silicon nitride layer 107, a sixth silicon nitride layer 108, a silicon oxynitride layer 109, and a third silicon oxide layer 110 arranged in sequence along a thickness direction thereof.

Referring to FIG. 2, a finished silicon wafer 20 is obtained by forming dense silicon oxide layers respective on front and back sides of the semi-finished silicon wafer through the atomic layer deposition process in the manufacturing method for the solar cell in the present disclosure. The finished silicon wafer 20 includes a second silicon oxide layer 202, the first silicon nitride layer 101, the second silicon nitride layer 102, the third silicon nitride layer 103, the aluminum oxide layer 104, the silicon layer 105, the fourth silicon nitride layer 106, the fifth silicon nitride layer 107, the sixth silicon nitride layer 108, the silicon oxynitride layer 109, the third silicon oxide layer 110, and a first silicon oxide layer 201 arranged in sequence along a thickness direction thereof.

The semi-finished silicon wafer is obtained by depositing coating layers respectively on back and front sides of a silicon wafer.

A method for depositing a coating layer on the back side of the silicon wafer includes:
using an PECVD two-in-one machine, firstly depositing an aluminum oxide layer on the back side of the silicon wafer that has been subjected to thermal oxidation to ensure the passivation effects on the back side, and then depositing a third silicon nitride layer, a second silicon nitride layer, and a first silicon nitride layer in sequence on a surface of the aluminum oxide layer.

The films/layers on the back side of the silicon wafer have an overall refractive index of 2.10 to 2.15 and a total thickness of 80 to 110 nm.

The aluminum oxide layer has a thickness of 5 to 15 nm.

In the process of depositing the aluminum oxide layer, nitrous oxide is introduced at a flow rate of 1000 to 10000 sccm, trimethylaluminum is introduced at a flow rate of 5 to 100 sccm, the silicon wafer substrate has a temperature of 280 to 350 °C, and the deposition is performed for a time period of 100 to 150 seconds.

Optionally, in the process of depositing the aluminum oxide layer, nitrous oxide is introduced at a flow rate of 3000 to 7000 sccm, and trimethylaluminum is introduced at a flow rate of 30 to 70 sccm,

The third silicon nitride layer has a thickness of 5 to 25 nm and a refractive index of 2.2 to 2.3.

The second silicon nitride layer has a thickness of 10 to 20 nm and a refractive index of 2.09 to 2.15.

The first silicon oxide layer has a thickness of 20 to 40 nm and a refractive index of 2 to 2.06.

In the process of depositing the silicon nitride layers on the back side of the silicon wafer, silane is introduced at a flow rate of 1 to 3000 sccm, ammonia gas is introduced at a flow rate of 1 to 20000 sccm, and the deposition is performed with a pressure of 800 to 2000 mTor, a power of 600 to 2000 W, and a temperature of 400 to 450°C.

Optionally, in the process of depositing the silicon nitride layers on the back side of the silicon wafer, the silane is introduced at a flow rate of 1000 to 2000 sccm, and the deposition is performed with a pressure of 1200 to 1800 mTor and a power of 1000 to 1500 W.

In the process of depositing the third silicon nitride layer, a ratio of the flow rates of the silane to the ammonia gas is 1:4 to 1:5, and the deposition is performed for a time period of 50 to 200 seconds.

In the process of depositing the second silicon nitride layer, a ratio of the flow rates of the silane to the ammonia gas is 1:7 to 1:9, and the deposition is performed for a time period of 100 to 200 seconds.

In the process of depositing the first silicon nitride layer, a ratio of the flow rates of the silane to the ammonia gas is 1:10 to 1:12, and the deposition is performed for a time period of 200 to 400 seconds.

A method for depositing a coating layer on the front side of the silicon wafer includes:
using the PECVD two-in-one machine, depositing a fourth silicon nitride layer, a fifth silicon nitride layer, a sixth silicon nitride layer, a silicon oxynitride layer, and a third silicon oxide layer in sequence on the front side of the silicon wafer that has been deposited with the back coating layer.

The films/layers on the front side of the silicon wafer have an overall refractive index of 2 to 2.05 and a total thickness of 65 to 80 nm.

The fourth silicon nitride layer has a thickness of 5 to 25 nm and a refractive index of 2.2 to 2.3.

The fifth silicon nitride layer has a thickness of 10 to 20 nm and a refractive index of 2.09 to 2.17.

The sixth silicon oxide layer has a thickness of 10 to 15 nm and a refractive index of 2.03 to 2.06.

In the process of depositing the silicon nitride layers on the front side of the silicon wafer, silane is introduced at a flow rate of 100 to 3000 sccm, ammonia gas is introduced at a flow rate of 100 to 20000 sccm, and the deposition is performed with a pressure of 800 to 2000 mTor, a power of 600 to 2000 W, and a temperature of 500 to 600 °C.

Optionally, in the process of depositing the silicon nitride layers on the front side of the silicon wafer, the silane is introduced at a flow rate of 1000 to 1500 sccm, and the deposition is performed at a pressure of 1200 to 1800 mTor and a power of 1000 to 1500 W.

In the process of depositing the fourth silicon nitride layer, a ratio of the flow rates of the silane to the ammonia gas is 1:4 to 1:5, and the deposition is performed for a time period of 50 to 200 seconds.

In the process of depositing the fifth silicon nitride layer, a ratio of the flow rates of the silane to the ammonia gas is 1:6 to 1:9, and the deposition is performed for a time period of 100 to 200 seconds.

In the process of depositing the sixth silicon nitride layer, a ratio of the flow rates of the silane to the ammonia gas is 1:10 to 1:11, and the deposition is performed for a time period of 100 to 120 seconds.

The silicon oxynitride layer has a thickness of 10 to 30 nm and a refractive index of 1.55 to 1.90.

In the process of depositing the silicon oxynitride layer, silane is introduced at a flow rate of 1 to 1000 sccm, ammonia gas is introduced at a flow rate of 1 to 10000 sccm, nitrous oxide is introduced at a flow rate of 1 to 10000 sccm, and the deposition is performed with a pressure of 800 to 2000 mTor, a power of 600 to 2000 W, and a temperature of 500 to 600°C.

Optionally, in the process of depositing the silicon oxynitride layer, silane is introduced at a flow rate of 300 to 1000 sccm, ammonia gas is introduced at a flow rate of 6000 to 10000 sccm, nitrous oxide is introduced at a flow rate of 5000 to 9000 sccm, and the deposition is performed with a pressure of 1200 to 1800 mTor and a power of 1000 to 1500 W.

The third silicon oxide layer has a thickness of 10 to 30 nm.

In the manufacturing method for the solar cell in the present disclosure, the dense silicon oxide layers can be respectively formed on the front side and the back side of the semi-finished silicon wafer through the atomic layer deposition process, which effectively blocks alkali metal ions from the glass of the module from passing through the films/layers of the solar cell and into the silicon wafer to damage the PN junction, thereby enhancing the PID resistance of the solar cell. Additionally, the dense silicon oxide layers formed by the atomic layer deposition process do not affect the reflection reduction effects on the front and back sides of the solar cell, the deposited layers on the front and back sides of the solar cell have a low refractive index, and the solar cell has a good short-wave response and increased absorption of blue light, which leads to a high short-circuit current and a high open-circuit voltage of the solar cell, thereby improving the photoelectric conversion efficiency of the solar cell.

Taken a monocrystalline P-type silicon wafer as an example, the present disclosure provides a manufacturing method for a solar cell, including:
S1, texturing: a monocrystalline P-type silicon wafer is textured with alkali at front and back sides thereof to form a textured surface with a pyramidal light-trapping structure;
S2, diffusion: the textured silicon wafer is reacted with phosphorus oxychloride at a high temperature to perform a diffusion at the front side to form an emitter PN junction, wherein a sheet resistance of a front surface after the diffusion is 150-190 Ω/sq;
S3, laser SE: using a phosphorosilicate glass (PSG) formed in the diffusion as a phosphorus source, a laser doping is performed in a metallized region on the front side of the diffused silicon wafer corresponding to a front electrode grid line to form a heavily doped region to obtain a selective emitter structure on the front side of the silicon wafer, wherein a sheet resistance of the heavily doped region is 80-100 Ω/sq;
S4, thermal oxidation: after the laser SE, the silicon wafer is oxidated by introducing oxygen to form an oxidation layer on the front surface to protect the PN junction at the front side from damage.
S5, removal of PSG: PSG produced on the back side and a lateral side of the thermally oxidated silicon wafer is removed with hydrofluoric acid;
S6, alkali polishing: the PSG-removed front and lateral sides of the silicon wafer are polished, while PSG on the front side is removed;
S7, oxidation and annealing: the alkali-polished silicon wafer is oxidated and annealed to form a silicon oxide layer on the surface thereof.
S8, deposition of passivation layer on back side: a coating layer is formed on the back side of the annealed silicon wafer according to the aforementioned method.
S9, deposition of reflection reduction film on front side: a coating layer is formed on the front side of the silicon wafer according to the aforementioned method to obtain a semi-finished silicon wafer;
S10, front and back dense silicon oxide layers: one silicon oxide layer is formed on each of the front and back sides of the semi-finished silicon wafer according to the aforementioned method;
S11, back laser treatment: laser opening for increasing contact is performed in a fine secondary grid region at the back side, but not to an aluminum primary grid and back electrode region, according to corresponding back laser pattern designed based on the back layout;
S12, back electrode preparation: after the laser opening at the back side, a back silver electrode and a PAD point are printed on the silicon wafer with a silver paste by screen printing;
S13, back electric field formation: an aluminum primary grid and an aluminum secondary grid are simultaneously printed with an aluminum paste by screen printing;
S14, printing in front electrode primary grid region: a front electrode is printed on the silicon wafer, which has already been printed with the back electrode, with a front silver paste by screen printing;
S15, printing in front secondary grid region: a front secondary grid is printed with a front silver paste according to a screen pattern;
S16, sintering: the silicon wafer printed with the front electrode is co-sintered;
S17, electrical injection: the sintered solar cell is subjected to an electrical injection;
S 18, finished product: the finished cell is tested, sorted, packaged, and stored.

It should be noted that the order of steps S8 and S9 can be interchanged, meaning that the deposition of the passivation layer on the back side and the deposition of the reflection reduction layer on the front side can be performed in either order.

The present disclosure further provides a solar cell that is manufactured according to the aforementioned manufacturing method for the solar cell.

In the above-described technical solution, the solar cell of the present disclosure has a good PID resistance and a high photoelectric conversion efficiency.

The solar cell and the manufacturing method therefor of the present disclosure will be further described in conjunction with examples below.

### Example 1

This example of the present disclosure provides a solar cell and a manufacturing method therefor, including the following steps:
S1, texturing: a monocrystalline P-type silicon wafer was textured with alkali at back and front sides thereof to form a textured surface with a pyramidal light-trapping structure;
S2, diffusion: the textured silicon wafer was reacted with phosphorus oxychloride at a high temperature to perform a diffusion at the front side to form an emitter PN junction, wherein a sheet resistance of a front surface after the diffusion was 165 Ω/sq;
S3, laser SE: using a phosphorosilicate glass (PSG) formed in the diffusion as a phosphorus source, a laser doping was performed in a metallized region on the front side of the diffused silicon wafer corresponding to a front electrode grid line to form a heavily doped region to obtain a selective emitter structure on the front side of the silicon wafer, wherein a sheet resistance of the heavily doped region was 90 Ω/sq;
S4, thermal oxidation: after the laser SE, the silicon wafer was oxidated by introducing oxygen to form an oxidation layer on the front surface to protect the PN junction at the front side from damage.
S5, removal of PSG: PSG produced on the back side and a lateral side of the thermally oxidated silicon wafer was removed with hydrofluoric acid;
S6, alkali polishing: the PSG-removed front and lateral sides of the silicon wafer were polished, while PSG on the front side was removed;
S7, oxidation and annealing: the alkali-polished silicon wafer was oxidated and annealed to form a silicon oxide layer on the surface thereof.
S8, deposition of passivation layer on back side: a coating layer was formed on the back side of the annealed silicon wafer using an PECVD two-in-one machine as follows: the silicon wafer substrate was kept at a temperature of 300 °C, nitrous oxide was introduced at a flow rate of 5000 sccm, trimethylaluminum was introduced at a flow rate of 60 sccm, and a deposition was performed for 120 seconds to obtain an aluminum oxide layer having a thickness of 8 nm; thereafter, vacuumizing was performed and the temperature was increased to 420 °C, silane was introduced at a flow rate of 1200 sccm, ammonia gas was introduced at a flow rate of 4800 sccm, and a deposition was performed for 200 seconds to obtain a third silicon nitride layer having a thickness of 24 nm; silane was introduced at a flow rate of 1200 sccm, ammonia gas was introduced at a flow rate of 9600 sccm, and a deposition was performed for 180 seconds to obtain a second silicon nitride layer having a thickness of 18 nm; silane was introduced at a flow rate of 1200 sccm, ammonia gas was introduced at a flow rate of 13200 sccm, and a deposition was performed for 400 seconds to obtain a first silicon nitride layer having a thickness of 40 nm; the films/layers on the back side of the silicon wafer had an overall refractive index of 2.13 and a total thickness of 90 nm;
S9, deposition of reflection reduction film on front side: a coating layer was formed on the front side of the silicon wafer that had already been formed with the back coating layer, using an PECVD two-in-one machine as follows: the silicon wafer substrate was kept at a temperature of 530 °C, silane was introduced at a flow rate of 1200 sccm, ammonia gas was introduced at a flow rate of 4800 sccm, and a deposition was performed for 120 seconds to obtain a fourth silicon nitride layer having a thickness of 15 nm and a refractive index of 2.3; silane was introduced at a flow rate of 1200 sccm, ammonia gas was introduced at a flow rate of 8400 sccm, and a deposition was performed for 100 seconds to obtain a fifth silicon nitride layer having a thickness of 10 nm and a refractive index of 2.15; silane was introduced at a flow rate of 1200 sccm, ammonia gas was introduced at a flow rate of 12000 sccm, and a deposition was performed for 120 seconds to obtain a sixth silicon nitride layer having a thickness of 15 nm and a refractive index of 2.06; thereafter, silane was introduced at a flow rate of 800 sccm, ammonia gas was introduced at a flow rate of 7000 sccm, nitrous oxide as introduced at a flow rate of 5000 sccm, and a deposition was performed for 130 seconds to obtain a silicon oxynitride layer having a thickness of 15 nm and a refractive index of 1.8; finally, silane was introduced at a flow rate of 200 sccm, nitrous oxide as introduced at a flow rate of 2000 sccm, and a deposition was performed for 150 seconds to obtain a porous third silicon oxide layer having a thickness of 20 nm; the films/layers on the front side of the silicon wafer had an overall refractive index of 2.03 and a total thickness of 75 nm.
S10, front and back dense silicon oxide layers: a first silicon oxide layer and a second silicon oxide layer were respectively formed on the front and back sides of the semi-finished silicon wafer by the following atomic layer deposition (ALD) process: the semi-finished silicon wafer was placed in a reaction chamber, under vacuum condition, hexachlorodisilane was firstly introduced into the reaction chamber at 25 sccm for 4 seconds so that hexachlorodisilane was chemically adsorbed onto the surface of the semi-finished silicon wafer substrate, and then ozone was introduced into the reaction chamber at 25 sccm for 10 seconds after the redundant hexachlorodisilane was expelled from the reaction chamber, so that the ozone reacted with the hexachlorodisilane on the surface of the semi-finished silicon wafer substrate to form a silicon oxide film, and the unreacted hexachlorodisilane and the unreacted ozone were expelled from the reaction chamber; a pressure in the reaction chamber was 25 mbar, and a temperature of the semi-finished silicon wafer was 300 °C; the above steps were cycled for 50 times to obtain the first silicon oxide layer and the second silicon oxide layer each having a thickness of 5 nm.
S11, back laser treatment: laser opening for increasing contact was performed in a fine secondary grid region at the back side, but not to an aluminum primary grid and back electrode region, according to corresponding back laser pattern designed based on the back layout;
S12, back electrode preparation: after the laser opening at the back side, a back silver electrode and a PAD point were printed on the silicon wafer with a silver paste by screen printing;
S13, back electric field formation: an aluminum primary grid and an aluminum secondary grid were simultaneously printed with an aluminum paste by screen printing using a screen having a mesh count of 360, a wire diameter of 16 µm, a mesh thickness of 28 µm, and a film thickness of 16 µm;
S14, printing in front electrode primary grid region: a front electrode was printed on the silicon wafer, which had already been printed with the back electrode, with a front silver paste by screen printing;
S15, printing in front secondary grid region: a front secondary grid was printed with a front silver paste according to a screen pattern using a screen having a mesh count of 520, a wire diameter of 17 µm, a mesh thickness of 11 µm, and a film thickness of 6 µm;
S16, sintering: the silicon wafer printed with the front electrode was co-sintered, wherein the peak temperature in the sintering was 760 °C;
S17, electrical injection: the sintered solar cell was subjected to an electrical injection;
S18, finished product: the finished cells were tested, sorted, packaged, and stored.

### Example 2

This example of the present disclosure provides a solar cell and a manufacturing method therefor, including the following steps:
S1, texturing: a monocrystalline P-type silicon wafer was textured with alkali at back and front sides thereof to form a textured surface with a pyramidal light-trapping structure;
S2, diffusion: the textured silicon wafer was reacted with phosphorus oxychloride at a high temperature to perform a diffusion at the front side to form an emitter PN junction, wherein a sheet resistance of a front surface after the diffusion was 165 Ω/sq;
S3, laser SE: using a phosphorosilicate glass (PSG) formed in the diffusion as a phosphorus source, a laser doping was performed in a metallized region on the front side of the diffused silicon wafer corresponding to a front electrode grid line to form a heavily doped region to obtain a selective emitter structure on the front side of the silicon wafer, wherein a sheet resistance of the heavily doped region was 90 Ω/sq;
S4, thermal oxidation: after the laser SE, the silicon wafer was oxidated by introducing oxygen to form an oxidation layer on the front surface to protect the PN junction at the front side from damage.
S5, removal of PSG: PSG produced on the back side and a lateral side of the thermally oxidated silicon wafer was removed with hydrofluoric acid;
S6, alkali polishing: the PSG-removed front and lateral sides of the silicon wafer were polished, while PSG on the front side was removed;
S7, oxidation and annealing: the alkali-polished silicon wafer was oxidated and annealed to form a silicon oxide layer on the surface thereof.
S8, deposition of passivation layer on back side: a coating layer was formed on the back side of the annealed silicon wafer using an PECVD two-in-one machine as follows: the silicon wafer substrate was kept at a temperature of 300 °C, nitrous oxide was introduced at a flow rate of 5000 sccm, trimethylaluminum was introduced at a flow rate of 60 sccm, and a deposition was performed for 120 seconds to obtain an aluminum oxide layer having a thickness of 8 nm; thereafter, vacuumizing was performed and the temperature was increased to 420°C, silane was introduced at a flow rate of 1200 sccm, ammonia gas was introduced at a flow rate of 4800 sccm, and a deposition was performed for 200 seconds to obtain a third silicon nitride layer having a thickness of 24 nm; silane was introduced at a flow rate of 1200 sccm, ammonia gas was introduced at a flow rate of 9600 sccm, and a deposition was performed for 180 seconds to obtain a second silicon nitride layer having a thickness of 18 nm; silane was introduced at a flow rate of 1200 sccm, ammonia gas was introduced at a flow rate of 13200 sccm, and a deposition was performed for 400 seconds to obtain a first silicon nitride layer having a thickness of 40 nm; the films/layers on the back side of the silicon wafer had an overall refractive index of 2.13 and a total thickness of 90 nm;
S9, deposition of reflection reduction film on front side: a coating layer was formed on the front side of the silicon wafer that had already been formed with the back coating layer, using the PECVD two-in-one machine as follows: the silicon wafer substrate was kept at a temperature of 530 °C, silane was introduced at a flow rate of 1200 sccm, ammonia gas was introduced at a flow rate of 4800 sccm, and a deposition was performed for 120 seconds to obtain a fourth silicon nitride layer having a thickness of 15 nm and a refractive index of 2.3; silane was introduced at a flow rate of 1200 sccm, ammonia gas was introduced at a flow rate of 8400 sccm, and a deposition was performed for 100 seconds to obtain a fifth silicon nitride layer having a thickness of 10 nm and a refractive index of 2.15; silane was introduced at a flow rate of 1200 sccm, ammonia gas was introduced at a flow rate of 12000 sccm, and a deposition was performed for 120 seconds to obtain a sixth silicon nitride layer having a thickness of 15 nm and a refractive index of 2.06; thereafter, silane was introduced at a flow rate of 800 sccm, ammonia gas was introduced at a flow rate of 7000 sccm, nitrous oxide as introduced at a flow rate of 5000 sccm, and a deposition was performed for 130 seconds to obtain a silicon oxynitride layer having a thickness of 15 nm and a refractive index of 1.8; finally, silane was introduced at a flow rate of 200 sccm, nitrous oxide as introduced at a flow rate of 2000 sccm, and a deposition was performed for 150 seconds to obtain a porous third silicon oxide layer having a thickness of 20 nm; the films/layers on the front side of the silicon wafer had an overall refractive index of 2.03 and a total thickness of 75 nm;
S10, front and back dense silicon oxide layers: a first silicon oxide layer and a second silicon oxide layer were respectively formed on the front and back sides of the semi-finished silicon wafer by the following atomic layer deposition (ALD) process: the semi-finished silicon wafer was placed in a reaction chamber, under vacuum condition, hexachlorodisilane was firstly introduced into the reaction chamber at 25 sccm for 4 seconds so that hexachlorodisilane was chemically adsorbed onto the surface of the semi-finished silicon wafer substrate, and then ozone was introduced into the reaction chamber at 25 sccm for 10 seconds after the redundant hexachlorodisilane was expelled from the reaction chamber, so that the ozone reacted with the hexachlorodisilane on the surface of the semi-finished silicon wafer substrate to form a silicon oxide film, and the unreacted hexachlorodisilane and the unreacted ozone were expelled from the reaction chamber; a pressure in the reaction chamber was 25 mbar, and a temperature of the semi-finished silicon wafer was 300 °C; the above steps were cycled for 100 times to obtain the first silicon oxide layer and the second silicon oxide layer each having a thickness of 10 nm.
S11, back laser treatment: laser opening for increasing contact was performed in a fine secondary grid region at the back side, but not to an aluminum primary grid and back electrode region, according to corresponding back laser pattern designed based on the back layout;
S12, back electrode preparation: after the laser opening at the back side, a back silver electrode and a PAD point were printed on the silicon wafer with a silver paste by screen printing;
S13, back electric field formation: an aluminum primary grid and an aluminum secondary grid were simultaneously printed with an aluminum paste by screen printing using a screen having a mesh count of 360, a wire diameter of 16 µm, a mesh thickness of 28 µm, and a film thickness of 16 µm;
S14, printing in front electrode primary grid region: a front electrode was printed on the silicon wafer, which had already been printed with the back electrode, with a front silver paste by screen printing;
S15, printing in front secondary grid region: a front secondary grid was printed with a front silver paste according to a screen pattern using a screen having a mesh count of 520, a wire diameter of 17 µm, a mesh thickness of 11 µm, and a film thickness of 6 µm;
S16, sintering: the silicon wafer printed with the front electrode was co-sintered, wherein the peak temperature in the sintering was 760 °C;
S17, electrical injection: the sintered solar cell was subjected to an electrical injection;
S18, finished product: the finished cells were tested, sorted, packaged, and stored.

### Comparative Example 1

This example of the present disclosure provides a solar cell and a manufacturing method therefor, including the following steps:
S1, texturing: a monocrystalline P-type silicon wafer was textured with alkali at back and front sides thereof to form a textured surface with a pyramidal light-trapping structure;
S2, diffusion: the textured silicon wafer was reacted with phosphorus oxychloride at a high temperature to perform a diffusion at the front side to form an emitter PN junction, wherein a sheet resistance of a front surface after the diffusion was 165 Ω/sq;
S3, laser SE: using a phosphorosilicate glass (PSG) formed in the diffusion as a phosphorus source, a laser doping was performed in a metallized region on the front side of the diffused silicon wafer corresponding to a front electrode grid line to form a heavily doped region to obtain a selective emitter structure on the front side of the silicon wafer, wherein a sheet resistance of the heavily doped region was 90 Ω/sq;
S4, thermal oxidation: after the laser SE, the silicon wafer was oxidated by introducing oxygen to form an oxidation layer on the front surface to protect the PN junction at the front side from damage.
S5, removal of PSG: PSG produced on the back side and a lateral side of the thermally oxidated silicon wafer was removed with hydrofluoric acid;
S6, alkali polishing: the PSG-removed front and lateral sides of the silicon wafer were polished, while PSG on the front side was removed;
S7, oxidation and annealing: the alkali-polished silicon wafer was oxidated and annealed to form a silicon oxide layer on the surface thereof.
S8, deposition of passivation layer on back side: a coating layer was formed on the back side of the annealed silicon wafer using an PECVD two-in-one machine as follows: the silicon wafer substrate was kept at a temperature of 300 °C, nitrous oxide was introduced at a flow rate of 5000 sccm, trimethylaluminum was introduced at a flow rate of 60 sccm, and a deposition was performed for 120 seconds to obtain an aluminum oxide layer having a thickness of 8 nm; thereafter, vacuumizing was performed and the temperature was increased to 420°C, silane was introduced at a flow rate of 1200 sccm, ammonia gas was introduced at a flow rate of 4800 sccm, and a deposition was performed for 200 seconds to obtain a third silicon nitride layer having a thickness of 24 nm; silane was introduced at a flow rate of 1200 sccm, ammonia gas was introduced at a flow rate of 9600 sccm, and a deposition was performed for 180 seconds to obtain a second silicon nitride layer having a thickness of 18 nm; silane was introduced at a flow rate of 1200 sccm, ammonia gas was introduced at a flow rate of 13200 sccm, and a deposition was performed for 400 seconds to obtain a first silicon nitride layer having a thickness of 40 nm; the films/layers on the back side of the silicon wafer had an overall refractive index of 2.13 and a total thickness of 90 nm;
S9, deposition of reflection reduction film on front side: a coating layer was formed on the front side of the silicon wafer that had already been formed with the back coating layer, using the PECVD two-in-one machine as follows: the silicon wafer substrate was kept at a temperature of 530 °C, silane was introduced at a flow rate of 1200 sccm, ammonia gas was introduced at a flow rate of 4800 sccm, and a deposition was performed for 120 seconds to obtain a fourth silicon nitride layer having a thickness of 15 nm and a refractive index of 2.3; silane was introduced at a flow rate of 1200 sccm, ammonia gas was introduced at a flow rate of 8400 sccm, and a deposition was performed for 220 seconds to obtain a fifth silicon nitride layer having a thickness of 20 nm and a refractive index of 2.15; silane was introduced at a flow rate of 1200 sccm, ammonia gas was introduced at a flow rate of 12000 sccm, and a deposition was performed for 350 seconds to obtain a sixth silicon nitride layer having a thickness of 35 nm and a refractive index of 2.06; the films/layers on the front side of the silicon wafer had an overall refractive index of 2.15 and a total thickness of 70 nm;
S10, back laser treatment: laser opening for increasing contact was performed in a fine secondary grid region at the back side, but not to an aluminum primary grid and back electrode region, according to corresponding back laser pattern designed based on the back layout;
S11, back electrode preparation: after the laser opening at the back side, a back silver electrode and a PAD point were printed on the silicon wafer with a silver paste by screen printing;
S12, back electric field formation: an aluminum primary grid and an aluminum secondary grid were simultaneously printed with an aluminum paste by screen printing using a screen having a mesh count of 360, a wire diameter of 16 µm, a mesh thickness of 28 µm, and a film thickness of 16 µm;
S13, printing in front electrode primary grid region: a front electrode was printed on the silicon wafer, which had already been printed with the back electrode, with a front silver paste by screen printing;
S14, printing in front secondary grid region: a front secondary grid was printed with a front silver paste according to a screen pattern using a screen having a mesh count of 520, a wire diameter of 17 µm, a mesh thickness of 11 µm, and a film thickness of 6 µm;
S15, sintering: the silicon wafer printed with the front electrode was co-sintered, wherein the peak temperature in the sintering was 760 °C;
S16, electrical injection: the sintered solar cell was subjected to an electrical injection;
S17, finished product: the finished cells were tested, sorted, packaged, and stored.

### Comparative Example 2

This example of the present disclosure provides a solar cell and a manufacturing method therefor, including the following steps:
S1, texturing: a monocrystalline P-type silicon wafer was textured with alkali at back and front sides thereof to form a textured surface with a pyramidal light-trapping structure;
S2, diffusion: the textured silicon wafer was reacted with phosphorus oxychloride at a high temperature to perform a diffusion at the front side to form an emitter PN junction, wherein a sheet resistance of a front surface after the diffusion was 165 Ω/sq;
S3, laser SE: using a phosphorosilicate glass (PSG) formed in the diffusion as a phosphorus source, a laser doping was performed in a metallized region on the front side of the diffused silicon wafer corresponding to a front electrode grid line to form a heavily doped region to obtain a selective emitter structure on the front side of the silicon wafer, wherein a sheet resistance of the heavily doped region was 90 Ω/sq;
S4, thermal oxidation: after the laser SE, the silicon wafer was oxidated by introducing oxygen to form an oxidation layer on the front surface to protect the PN junction at the front side from damage.
S5, removal of PSG: PSG produced on the back side and a lateral side of the thermally oxidated silicon wafer was removed with hydrofluoric acid;
S6, alkali polishing: the PSG-removed front and lateral sides of the silicon wafer were polished, while PSG on the front side was removed;
S7, oxidation and annealing: the alkali-polished silicon wafer was oxidated and annealed to form a silicon oxide layer on the surface thereof;
S8, deposition of passivation layer on back side: a coating layer was performed on the back side of the annealed silicon wafer using an PECVD two-in-one machine as follows: the silicon wafer substrate was kept at a temperature of 300 °C, nitrous oxide was introduced at a flow rate of 5000 sccm, trimethylaluminum was introduced at a flow rate of 60 sccm, and a deposition was performed for 120 seconds to obtain an aluminum oxide layer having a thickness of 8 nm; thereafter, vacuumizing was performed and the temperature was increased to 420°C, silane was introduced at a flow rate of 1200 sccm, ammonia gas was introduced at a flow rate of 4800 sccm, and a deposition was performed for 200 seconds to obtain a third silicon nitride layer having a thickness of 24 nm; silane was introduced at a flow rate of 1200 sccm, ammonia gas was introduced at a flow rate of 9600 sccm, and a deposition was performed for 180 seconds to obtain a second silicon nitride layer having a thickness of 18 nm; silane was introduced at a flow rate of 1200 sccm, ammonia gas was introduced at a flow rate of 13200 sccm, and a deposition was performed for 400 seconds to obtain a first silicon nitride layer having a thickness of 40 nm; the films/layers on the back side of the silicon wafer had an overall refractive index of 2.13 and a total thickness of 90 nm;
S9, deposition of reflection reduction film on front side: a coating layer was formed on the front side of the silicon wafer that had already been formed with the back coating layer, using the PECVD two-in-one machine as follows: the silicon wafer substrate was kept at a temperature of 530°C, silane was introduced at a flow rate of 1200 sccm, ammonia gas was introduced at a flow rate of 4800 sccm, and a deposition was performed for 120 seconds to obtain a fourth silicon nitride layer having a thickness of 15 nm and a refractive index of 2.3; silane was introduced at a flow rate of 1200 sccm, ammonia gas was introduced at a flow rate of 8400 sccm, and a deposition was performed for 100 seconds to obtain a fifth silicon nitride layer having a thickness of 10 nm and a refractive index of 2.15; silane was introduced at a flow rate of 1200 sccm, ammonia gas was introduced at a flow rate of 12000 sccm, and a deposition was performed for 120 seconds to obtain a sixth silicon nitride layer having a thickness of 15 nm and a refractive index of 2.06; thereafter, silane was introduced at a flow rate of 800 sccm, ammonia gas was introduced at a flow rate of 7000 sccm, nitrous oxide as introduced at a flow rate of 5000 sccm, and a deposition was performed for 130 seconds to obtain a silicon oxynitride layer having a thickness of 15 nm and a refractive index of 1.8; finally, silane was introduced at a flow rate of 200 sccm, nitrous oxide as introduced at a flow rate of 2000 sccm, and a deposition was performed for 150 seconds to obtain a porous third silicon oxide layer having a thickness of 20 nm; the films/layers on the front side of the silicon wafer had an overall refractive index of 2.03 and a total thickness of 75 nm;
S10, front and back non-dense silicon oxide layers: a first silicon oxide layer and a second silicon oxide layer were respectively formed on the front and back sides of the semi-finished silicon wafer using the PECVD two-in-one machine as follows: the silicon wafer substrate was kept at a temperature of 530°C, silane was introduced at a flow rate of 600 sccm, ammonia gas was introduced at a flow rate of 12000 sccm, and a deposition was performed for 180 seconds to obtain the first silicon oxide layer and the second silicon oxide layer each having a thickness of 15 nm and a refractive index of 1.45.
S11, back laser treatment: laser opening for increasing contact was performed in a fine secondary grid region at the back side, but not to an aluminum primary grid and back electrode region, according to corresponding back laser pattern designed based on the back layout;
S12, back electrode preparation: after the laser opening at the back side, a back silver electrode and a PAD point were printed on the silicon wafer with a silver paste by screen printing;
S13, back electric field formation: an aluminum primary grid and an aluminum secondary grid were simultaneously printed with an aluminum paste by screen printing using a screen having a mesh count of 360, a wire diameter of 16 µm, a mesh thickness of 28 µm, and a film thickness of 16 µm;
S14, printing in front electrode primary grid region: a front electrode was printed on the silicon wafer, which had already been printed with the back electrode, with a front silver paste by screen printing;
S15, printing in front secondary grid region: a front secondary grid was printed with a front silver paste according to a screen pattern using a screen having a mesh count of 520, a wire diameter of 17 µm, a mesh thickness of 11 µm, and a film thickness of 6 µm;
S16, sintering: the silicon wafer printed with the front electrode was co-sintered, wherein the peak temperature in the sintering was 760°C;
S17, electrical injection: the sintered solar cell was subjected to an electrical injection;
S18, finished product: the finished cells were tested, sorted, packaged, and stored.

### Test Example 1

Under standard testing conditions of -1500V, 85% humidity, and 85°C (according to IEC61215 or UL1703 standards), the front PID degradations at 96 hours (96H) and 192 hours (192H) of solar cells manufactured in Examples 1 to 2 and Comparative Examples 1 to 2 were tested. The results are shown in Table 1.

**Table 1: Front PID Degradation at 96H and 192H of Solar Cells**

| Item | Degradation at 96H | Degradation at 192H |
|---|---|---|
| Example 1 | 0.95% | 1.87% |
| Example 2 | 0.16% | 0.33% |
| Comparative Example 1 | 1.87% | 3.59% |
| Comparative Example 2 | 3.73% | 5.36% |

From Table 1, it can be seen that the front-film process used in Comparative Example 2, where the front outermost layer is a loose silicon oxide prepared by PECVD, results in PID degradation exceeding the standard. The front film of Comparative Example 2 is a three-layer pure silicon nitride structure, which shows significant improvement in PID degradation compared to Comparative Example 2. Example 1, having a dense silicon oxide layer of 5nm thickness prepared by ALD on both the front and back sides based on Comparative Example 2, greatly enhances the PID resistance. Example 2, having further increased thickness of the dense silicon oxide, further decreases the PID degradation. Comparative Example 1, lacking the dense silicon oxide layer on the front and back sides based on Example 1, shows an increase in PID degradation.

### Test Example 2

The electrical performances of the solar cells manufactured in Examples 1 to 2 and Comparative Examples 1 to 2 were tested, and the results are shown in Table 2.

**Table 2: Electrical Performance of Solar Cells**

| Item | Count | Eta | Uoc | Isc | FF |
|---|---|---|---|---|---|
| Comparative Example 1 | 800 | 22.91 | 0.6880 | 18.158 | 80.87 |
| Comparative Example 2 | 800 | 23.03 | 0.6889 | 18.268 | 80.71 |
| Example 1 | 800 | 22.96 | 0.6887 | 18.221 | 80.67 |
| Example 2 | 800 | 23.01 | 0.6888 | 18.258 | 80.70 |

From Tables 1 and 2, it can be seen that although Comparative Example 1 shows improved front PID resistance compared to Comparative Example 2, its cell conversion efficiency is low. Both Examples 1 and 2 meet the PID resistance requirements while also satisfying the cell conversion efficiency requirements.

In summary, the solar cells produced in the embodiments of the present disclosure exhibit front PID degradation of <1% at 96 hours and <2% at 192 hours.

## Claims

1. A method for manufacturing a solar cell, comprising: providing a semi-finished silicon wafer (10), and forming a first silicon oxide layer (201) and a second silicon oxide layer (202) respectively on a front side and a back side of the semi-finished silicon wafer (10) through an atomic layer deposition process;
wherein the semi-finished silicon wafer (10) comprises at least one back silicon nitride layer (101, 102, 103), an aluminum oxide layer (104), a silicon layer (105), at least one front silicon nitride layer (106, 107, 108), a silicon oxynitride layer (109), and a third silicon oxide layer (110) arranged in sequence along a thickness direction thereof, the first silicon oxide layer (201) is bound to a surface of the third silicon oxide layer (110), and the second silicon oxide layer (202) is bound to a surface of the back silicon nitride layer;
wherein the first silicon oxide layer (201) and the second silicon oxide layer (202) each independently have a thickness of 5 to 10 nm.

2. The method for manufacturing the solar cell of claim 1, wherein the atomic layer deposition process comprises the following steps:
placing the semi-finished silicon wafer (10) in a reaction chamber, introducing a gaseous silicon-based precursor into the reaction chamber at a flow rate of 10 to 50 sccm for 2 to 5 seconds, and then introducing a gaseous oxidant precursor into the reaction chamber at a flow rate of 10 to 50 sccm for 5 to 15 seconds;
wherein the above steps are recycled for 50 to 100 times.

3. The method for manufacturing the solar cell of claim 2, wherein the reaction chamber is under vacuum condition before the introducing the gaseous silicon-based precursor.

4. The method for manufacturing the solar cell of claim 2 or 3, wherein the silicon-based precursor comprises hexachlorodisilane, bis(diethylamino)silane, tris(dimethylamino)silane, trisilylamine, or any combination thereof, and the oxidant comprises oxygen, ozone, or a combination thereof.

5. The method for manufacturing the solar cell of any one of claims 2 to 4, wherein a pressure in the reaction chamber is 2 to 50 mbar, and a temperature of the semi-finished silicon wafer (10) is 150 to 400 °C.

6. The method for manufacturing the solar cell of any one of claims 2 to 5, wherein after the introducing the gaseous silicon-based precursor each time, the gaseous silicon-based precursor is adsorbed onto a surface of the semi-finished silicon wafer (10), and the method comprises expelling any redundant gaseous silicon-based precursor from the reaction chamber before the introducing the gaseous oxidant precursor into the reaction chamber; and wherein a reaction of the gaseous oxidant precursor and the gaseous silicon-based precursor adsorbed onto the surface of the semi-finished silicon wafer (10) is performed in the reaction chamber, and the method comprises expelling any unreacted gaseous silicon-based precursor and any unreacted gaseous oxidant precursor from the reaction chamber after the reaction is completed and before the next cycle of deposition.

7. The method for manufacturing the solar cell of any one of claims 1 to 6, wherein the semi-finished silicon wafer (10) is manufactured by the following steps:
depositing a back coating layer and a front coating layer respectively on a back side and a front side of a silicon wafer;
wherein the back coating layer on the back side comprises a first silicon nitride layer (101), a second silicon nitride layer (102), a third silicon nitride layer (103), and the aluminum oxide layer (104), and the front coating layer on the front side comprises a fourth silicon nitride layer (106), a fifth silicon nitride layer (107), a sixth silicon nitride layer (108), the silicon oxynitride layer (109), and the third silicon oxide layer (110).

8. The method for manufacturing the solar cell of claim 7, wherein the aluminum oxide layer (104), the third silicon nitride layer (103), the second silicon nitride layer (102), and the first silicon nitride layer (101) are sequentially deposited on the back side of the silicon wafer through a vapor deposition process.

9. The method for manufacturing the solar cell of claim 7 or 8, wherein the third silicon nitride layer (103) has a refractive index of 2.20 to 2.30, the second silicon nitride layer (102) has a refractive index of 2.09 to 2.15, and the first silicon nitride layer (101) has a refractive index of 2.00 to 2.06.

10. The method for manufacturing the solar cell of any one of claims 7 to 9, wherein the back coating layer on the back side has a refractive index of 2.10 to 2.15.

11. The method for manufacturing the solar cell of any one of claims 7 to 10, wherein the fourth silicon nitride layer (106), the fifth silicon nitride layer (107), the sixth silicon nitride layer (108), the silicon oxynitride layer (109), and the third silicon oxide layer (110) are sequentially deposited on the front side of the silicon wafer through a vapor deposition process.

12. The method for manufacturing the solar cell of any one of claims 7 to 11, wherein the fourth silicon nitride layer (106) has a refractive index of 2.20 to 2.30, the fifth silicon nitride layer (107) has a refractive index of 2.06 to 2.17, the sixth silicon nitride layer (108) has a refractive index of 2.03 to 2.06, and the silicon oxynitride layer (110) has a refractive index of 1.55 to 1.90.

13. The method for manufacturing the solar cell of any one of claims 7 to 12, wherein the front coating layer on the front side has a refractive index of 2.00 to 2.05.

## Patentansprüche

1. Verfahren zum Herstellen einer Solarzelle, umfassend: Bereitstellen eines halbfertigen Siliciumwafers (10) und Bilden, mithilfe eines Atomschichtabscheidungsprozesses, einer ersten Siliciumoxidschicht (201) und einer zweiten Siliciumoxidschicht (202) auf einer Vorderseite bzw. einer Rückseite des halbfertigen Siliciumwafers (10);
wobei der halbfertige Siliciumwafer (10) mindestens eine hintere Siliciumnitridschicht (101, 102, 103), eine Aluminiumoxidschicht (104), eine Siliciumschicht (105), mindestens eine vordere Siliciumnitridschicht (106, 107, 108), eine Siliciumoxynitridschicht (109) und eine dritte Siliciumoxidschicht (110) umfasst, die entlang einer Dickenrichtung desselben der Reihe nach angeordnet sind, wobei die erste Siliciumoxidschicht (201) an eine Oberfläche (110) der dritten Siliciumoxidschicht gebunden, und die zweite Siliciumoxidschicht (202) an eine Oberfläche der hinteren Siliciumnitridschicht gebunden ist;
wobei die erste Siliciumoxidschicht (201) und die zweite Siliciumoxidschicht (202) jeweils unabhängig voneinander eine Dicke von 5 bis 10 nm aufweisen.

2. Verfahren zum Herstellen der Solarzelle nach Anspruch 1, wobei der Atomschichtabscheidungsprozess die folgenden Schritte umfasst:
Platzieren des halbfertigen Siliciumwafers (10) in eine Reaktionskammer, Einführen eines gasförmigen siliciumbasierten Vorläufers in die Reaktionskammer mit einer Flussrate von 10 bis 50 sccm für 2 bis 5 Sekunden und danach Einführen eines gasförmigen Oxidationsmittelvorläufers in die Reaktionskammer mit einer Flussrate von 10 bis 50 sccm für 5 bis 15 Sekunden;
wobei die obigen Schritte 50 bis 100 Mal wiederholt durchlaufen werden.

3. Verfahren zum Herstellen der Solarzelle nach Anspruch 2, wobei die Reaktionskammer vor dem Einführen des gasförmigen siliciumbasierten Vorläufers unter einer Vakuumbedingung steht.

4. Verfahren zum Herstellen der Solarzelle nach Anspruch 2 oder 3, wobei der siliciumbasierte Vorläufer Hexachlordisilan, Bis(diethylamino)silan, Tris(dimethylamino)silan, Trisilylamin oder eine beliebige Kombination davon umfasst und das Oxidationsmittel Sauerstoff, Ozon oder eine Kombination davon umfasst.

5. Verfahren zum Herstellen der Solarzelle nach einem der Ansprüche 2 bis 4, wobei ein Druck in der Reaktionskammer 2 bis 50 mbar beträgt und wobei eine Temperatur des halbfertigen Siliziumwafers (10) 150 bis 400°C beträgt.

6. Verfahren zum Herstellen der Solarzelle nach einem der Ansprüche 2 bis 5, wobei nach dem Einführen des gasförmigen siliciumbasierte Vorläufers der gasförmige siliciumbasierte Vorläufer auf einer Oberfläche des halbfertigen Siliciumwafers (10) adsorbiert wird und wobei das Verfahren ein Ausstoßen von jeglichem redundanten gasförmigen siliciumbasierten Vorläufer aus der Reaktionskammer vor dem Einführen des gasförmigen Oxidationsmittelvorläufers in die Reaktionskammer umfasst; und wobei eine Reaktion des gasförmigen Oxidationsmittelvorläufers und des siliciumbasierten Vorläufers, der auf der Oberfläche des halbfertigen Siliciumwafers (10) adsorbiert wurde, in der Reaktionskammer durchgeführt wird, und wobei das Verfahren ein Ausstoßen von jeglichem unreagierten gasförmigen siliciumbasierten Vorläufer und jeglichem unreagierten gasförmigen Oxidationsmittelvorläufers aus der Reaktionskammer, nachdem die Reaktion abgeschlossen wurde und vor dem nächsten Abscheidungszyklus, umfasst.

7. Verfahren zum Herstellen der Solarzelle nach einem der Ansprüche 1 bis 6, wobei der halbfertige Siliciumwafer (10) durch die folgenden Schritte hergestellt wird:
Abscheiden einer hinteren Deckschicht und einer vorderen Deckschicht auf eine Rückseite bzw. eine Vorderseite eines Siliciumwafers;
wobei die hintere Deckschicht auf der Rückseite eine erste Siliciumnitridschicht (101), eine zweite Siliciumnitridschicht (102), eine dritte Siliciumnitridschicht (103) und die Aluminiumoxidschicht (104) umfasst und wobei die vordere Deckschicht auf der Vorderseite eine vierte Siliciumnitridschicht (106), eine fünfte Siliciumnitridschicht (107), eine sechste Siliciumnitridschicht (108), die Siliciumoxynitridschicht (109) und die dritte Siliciumoxidschicht (110) umfasst.

8. Verfahren zum Herstellen der Solarzelle nach Anspruch 7, wobei die Aluminiumoxidschicht (104), die dritte Siliciumnitridschicht (103), die zweite Siliciumnitridschicht (102) und die erste Siliciumnitridschicht (101) der Reihe nach auf der Rückseite des Siliciumwafers mithilfe eines Dampfabscheidungsprozesses abgeschieden werden.

9. Verfahren zum Herstellen der Solarzelle nach Anspruch 7 oder 8, wobei die dritte Siliciumnitridschicht (103) einen Brechungsindex von 2,20 bis 2,30 aufweist, die zweite Siliciumnitridschicht (102) einen Brechungsindex von 2,09 bis 2,15 aufweist und die erste Siliciumnitridschicht (101) einen Brechungsindex von 2,00 bis 2,06 aufweist.

10. Verfahren zum Herstellen der Solarzelle nach einem der Ansprüche 7 bis 9, wobei die hintere Deckschicht auf der Rückseite einen Brechungsindex von 2,10 bis 2,15 aufweist.

11. Verfahren zum Herstellen der Solarzelle nach einem der Ansprüche 7 bis 10, wobei die vierte Siliciumnitridschicht (106), die fünfte Siliciumnitridschicht (107), die sechste Siliciumnitridschicht (108), die Siliciumoxynitridschicht (109) und die dritte Siliciumoxidschicht (110) der Reihe nach auf der Vorderseite des Siliciumwafers mithilfe eines Dampfabscheidungsprozesses abgeschieden werden.

12. Verfahren zum Herstellen der Solarzelle nach einem der Ansprüche 7 bis 11, wobei die vierte Siliciumnitridschicht (106) einen Brechungsindex von 2,20 bis 2,30 aufweist, die fünfte Siliciumnitridschicht (107) einen Brechungsindex von 2,06 bis 2,17 aufweist, die sechste Siliciumnitridschicht (108) einen Brechungsindex von 2,03 bis 2,06 aufweist und die Siliciumoxynitridschicht (110) einen Brechungsindex von 1,55 bis 1,90 aufweist.

13. Verfahren zum Herstellen der Solarzelle nach einem der Ansprüche 7 bis 12, wobei die vordere Deckschicht auf der Vorderseite einen Brechungsindex von 2,00 bis 2,05 aufweist.

## Revendications

1. Un procédé de fabrication d'une cellule solaire, comprenant : la fourniture d'une tranche de silicium semi-finie (10), et la formation d'une première couche d'oxyde de silicium (201) et d'une deuxième couche d'oxyde de silicium (202) respectivement sur une face avant et une face arrière de la tranche de silicium semi-finie (10) par un procédé de dépôt par couches atomiques ;
dans lequel la tranche de silicium semi-finie (10) comprend au moins une couche arrière de nitrure de silicium (101, 102, 103), une couche d'oxyde d'aluminium (104), une couche de silicium (105), au moins une couche avant de nitrure de silicium (106, 107, 108), une couche d'oxynitrure de silicium (109) et une troisième couche d'oxyde de silicium (110), agencées en séquence suivant une direction d'épaisseur de celle-ci, la première couche d'oxyde de silicium (201) est liée à une surface de la troisième couche d'oxyde de silicium (110), et la deuxième couche d'oxyde de silicium (202) est liée à une surface de la couche arrière de nitrure de silicium ;
dans lequel la première couche d'oxyde de silicium (201) et la deuxième couche d'oxyde de silicium (202) ont chacune indépendamment une épaisseur de 5 à 10 nm.

2. Le procédé de fabrication de la cellule solaire selon la revendication 1, dans lequel le procédé de dépôt par couches atomiques comprend les étapes suivantes :
le placement de la tranche de silicium semi-finie (10) dans une chambre de réaction, l'introduction d'un précurseur gazeux à base de silicium dans la chambre de réaction à un débit de 10 à 50 sccm pendant 2 à 5 secondes, puis l'introduction d'un précurseur oxydant gazeux dans la chambre de réaction à un débit de 10 à 50 sccm pendant 5 à 15 secondes ;
dans lequel les étapes ci-dessus sont répétées 50 à 100 fois.

3. Le procédé de fabrication de la cellule solaire selon la revendication 2, dans lequel la chambre de réaction est sous vide avant l'introduction du précurseur gazeux à base de silicium.

4. Le procédé de fabrication de la cellule solaire selon la revendication 2 ou 3, dans lequel le précurseur à base de silicium comprend de l'hexachlorodisilane, du bis(diéthylamino)silane, du tris(diméthylamino)silane, de la trisilylamine ou une quelconque combinaison de ceux-ci, et l'oxydant comprend de l'oxygène, de l'ozone ou une combinaison de ceux-ci.

5. Le procédé de fabrication de la cellule solaire selon l'une quelconque des revendications 2 à 4, dans lequel une pression dans la chambre de réaction est de 2 à 50 mbar, et une température de la tranche de silicium semi-finie (10) est de 150 à 400 °C.

6. Le procédé de fabrication de la cellule solaire selon l'une quelconque des revendications 2 à 5, dans lequel, après l'introduction chaque fois du précurseur gazeux à base de silicium, le précurseur gazeux à base de silicium est adsorbé sur une surface de la tranche de silicium semi-finie (10), et le procédé comprend l'expulsion de tout précurseur gazeux à base de silicium en excès de la chambre de réaction avant l'introduction du précurseur oxydant gazeux dans la chambre de réaction ; et dans lequel une réaction entre le précurseur oxydant gazeux et le précurseur gazeux à base de silicium adsorbé sur la surface de la tranche de silicium semi-finie (10) est effectuée dans la chambre de réaction, et le procédé comprend l'expulsion de tout précurseur gazeux à base de silicium n'ayant pas réagi et de tout précurseur oxydant gazeux n'ayant pas réagi de la chambre de réaction après l'achèvement de la réaction et avant le cycle de dépôt suivant.

7. Le procédé de fabrication de la cellule solaire selon l'une quelconque des revendications 1 à 6, dans lequel la tranche de silicium semi-finie (10) est fabriquée par les étapes suivantes :
la déposition d'une couche de revêtement arrière et une couche de revêtement avant respectivement sur une face arrière et une face avant d'une tranche de silicium ;
dans lequel la couche de revêtement arrière sur la face arrière comprend une première couche de nitrure de silicium (101), une deuxième couche de nitrure de silicium (102), une troisième couche de nitrure de silicium (103) et la couche d'oxyde d'aluminium (104), et la couche de revêtement avant sur la face avant comprend une quatrième couche de nitrure de silicium (106), une cinquième couche de nitrure de silicium (107), une sixième couche de nitrure de silicium (108), la couche d'oxynitrure de silicium (109) et la troisième couche d'oxyde de silicium (110).

8. Le procédé de fabrication de la cellule solaire selon la revendication 7, dans lequel la couche d'oxyde d'aluminium (104), la troisième couche de nitrure de silicium (103), la deuxième couche de nitrure de silicium (102) et la première couche de nitrure de silicium (101) sont déposées successivement sur la face arrière de la tranche de silicium par un procédé de dépôt en phase vapeur.

9. Le procédé de fabrication de la cellule solaire selon la revendication 7 ou 8, dans lequel la troisième couche de nitrure de silicium (103) présente un indice de réfraction de 2,20 à 2,30, la deuxième couche de nitrure de silicium (102) présente un indice de réfraction de 2,09 à 2,15, et la première couche de nitrure de silicium (101) présente un indice de réfraction de 2,00 à 2,06.

10. Le procédé de fabrication de la cellule solaire selon l'une quelconque des revendications 7 à 9, dans lequel la couche de revêtement arrière sur la face arrière présente un indice de réfraction de 2,10 à 2,15.

11. Le procédé de fabrication de la cellule solaire selon l'une quelconque des revendications 7 à 10, dans lequel la quatrième couche de nitrure de silicium (106), la cinquième couche de nitrure de silicium (107), la sixième couche de nitrure de silicium (108), la couche d'oxynitrure de silicium (109) et la troisième couche d'oxyde de silicium (110) sont déposées successivement sur la face avant de la tranche de silicium par un procédé de dépôt en phase vapeur.

12. Le procédé de fabrication de la cellule solaire selon l'une quelconque des revendications 7 à 11, dans lequel la quatrième couche de nitrure de silicium (106) présente un indice de réfraction de 2,20 à 2,30, la cinquième couche de nitrure de silicium (107) présente un indice de réfraction de 2,06 à 2,17, la sixième couche de nitrure de silicium (108) présente un indice de réfraction de 2,03 à 2,06, et la couche d'oxynitrure de silicium (110) présente un indice de réfraction de 1,55 à 1,90.

13. Le procédé de fabrication de la cellule solaire selon l'une quelconque des revendications 7 à 12, dans lequel la couche de revêtement avant sur la face avant présente un indice de réfraction de 2,00 à 2,05.
